# EUROPEAN PATENT SPECIFICATION

(11) **EP 3 780 113 B1**
(45) Date of publication and mention of the grant of the patent: **16.07.2025**
(21) Application number: 20199618.8
(22) Date of filing: 31.07.2013
(51) Int. Cl.: H10K 59/00

(54) **PIXEL ARRANGEMENT STRUCTURE FOR ORGANIC LIGHT EMITTING DIODE DISPLAY**
PIXELANORDNUNGSSTRUKTUR EINER ORGANISCHEN LICHTEMITTIERENDEN DIODENANZEIGE
STRUCTURE DE DISPOSITION DE PIXELS POUR DISPOSITIF D'AFFICHAGE À DIODES ÉLECTROLUMINESCENTES ORGANIQUES

(30) Priority: 13.09.2012 US 201213614197; 23.04.2013 KR 20130044993
(43) Date of publication of application: 17.02.2021
(62) Divisional of application: 13178648.5
(73) Proprietor: Samsung Display Co., Ltd., Yongin-si Gyeonggi-do 17113 (KR)
(72) Inventor: Lee, Sang Shin, Hwaseong-si (KR)
(74) Representative: Gulde & Partner

(56) References cited:
- EP-A1- 2 637 209
- US-A1- 2008 001 525

## Description

### BACKGROUND

### 1. Field

Aspects of embodiments of the present invention relate generally to a pixel arrangement structure for an organic light emitting diode (OLED) display.

### 2. Description of the Related Art

A display device is a device that displays an image. Recently, an OLED display has been drawing attention.

The OLED display has a self-luminous characteristic. Because the OLED display does not need a separate light source, unlike a liquid crystal display, it can have a relatively smaller thickness and weight than liquid crystal displays. In addition, the OLED display exhibits high-quality characteristics such as low power consumption, high luminance, high response speed, etc.

In general, the OLED display includes a plurality of pixels for emitting light of different colors. The plurality of pixels emit light to display an image.

Here, the pixel refers to a minimum unit for displaying the images. For instance, there may be a gate line, a data line, and a power line such as a driving power line to drive each pixel. In addition, there may be an insulation layer such as a pixel definition layer to define an area and a shape of each pixel. Further, each pixel may be positioned between its neighboring pixels.

An organic emission layer included in the pixel of an OLED display may be deposited and formed by using a mask such as a fine metal mask (FMM). When reducing a gap between the neighboring pixels to obtain a high aperture ratio of the pixels, deposition reliability may be deteriorated. On the other hand, when increasing the gap between the pixels to improve the deposition reliability, the aperture ratio of the pixels may be deteriorated.

For instance, EP 2 637 209 A1 - which constitutes prior art under Art. 54(3) EPC - is directed to a pixel arrangement for an OLED display, wherein the pixels may have different polygonal shapes. Furthermore, US 2008/0001525 A1 and US2002/0015110 A1 both disclose a pixel arrangement for display panels wherein pixels of a first color are surrounded by four pixels of different colors.

The above information disclosed in this Background section is only for enhancement of understanding of the background of the invention and therefore it may contain information that does not form the prior art that is already known in this country to a person of ordinary skill in the art.

### SUMMARY

Aspects of embodiments of the present invention relate generally to a pixel arrangement structure for an OLED display. More particularly, aspects of embodiments of the present invention relate to a pixel arrangement structure of an OLED display that displays an image by emitting light through a plurality of pixels.

An exemplary embodiment of the present invention provides a pixel arrangement structure for an OLED display having an improved aperture ratio of each of the pixels while efficiently setting up gaps between the pixels.

According to an exemplary embodiment of the present invention, a pixel arrangement structure of an organic light emitting diode (OLED) display is provided according to claim 1.

The further embodiments are defined in dependent claims.

According to an exemplary embodiment of the present invention, the pixel arrangement structure of the OLED display improves the aperture ratio of the pixels while efficiently setting up the gaps between the pixels.

### BRIEF DESCRIPTION OF THE DRAWING

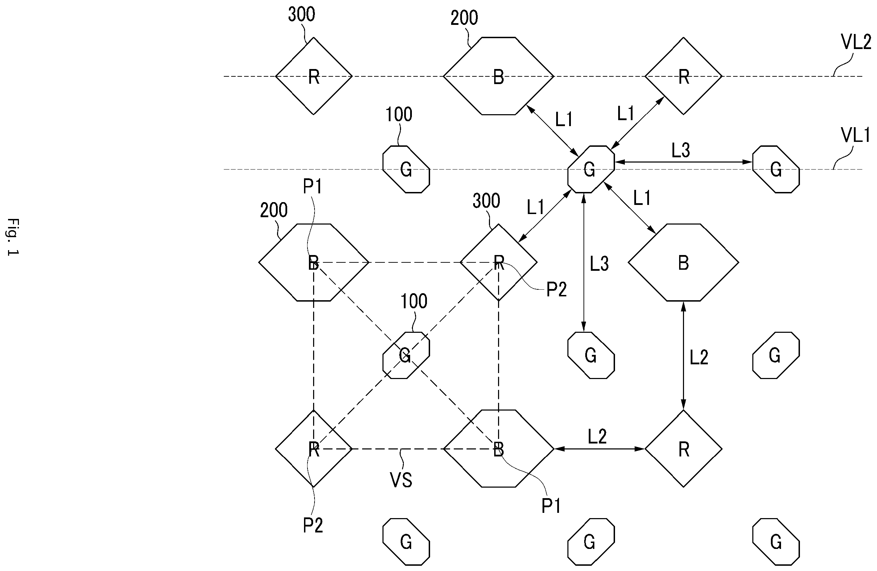

Fig. 1 is a view of a pixel arrangement structure of an OLED display according to an exemplary embodiment of the present invention.

### DETAILED DESCRIPTION

Several exemplary embodiments according to the present invention are described hereinafter in detail with reference to the accompanying drawing to allow one of ordinary skill in the art to practice the invention without undue experimentation. The present invention can be embodied in several different forms, and is not limited to the exemplary embodiments that are described herein.

In order to clarify the description of embodiments of the present invention, parts that are not related to the invention may be omitted. In addition, the same elements or equivalents are referred to with the same reference numerals throughout the specification.

Further, since sizes and thicknesses of constituent members shown in the accompanying drawing may be arbitrarily given for better understanding and ease of description, the present invention is not limited to the illustrated sizes and thicknesses.

In addition, unless explicitly described to the contrary, the word "comprise" and variations such as "comprises" or "comprising" will be understood to imply the inclusion of stated elements but not the exclusion of any other elements.

Hereinafter, a pixel arrangement structure (or pixel arrangement) of an OLED display according to an exemplary embodiment will be described with reference to Fig. 1. The drawing is a view schematically showing a portion of pixels forming an OLED display.

Fig. 1 shows a pixel arrangement structure of an OLED display according to an exemplary embodiment of the present invention.

As shown in Fig. 1, the pixel arrangement structure of the OLED display includes a plurality of first pixels 100, a plurality of second pixels 200, and a plurality of third pixels 300.

According to one embodiment, the pixel refers to a minimum unit for displaying an image (for example, the minimum addressable unit of the display).

In one embodiment, power lines such as a gate line, a data line, a driving power line, and the like, are located among the first pixels 100, the second pixels 200, and the third pixels 300, for driving each of the pixels. In addition, in one embodiment, an insulation layer, such as a pixel defining layer, is provided for defining each of the pixels. Further, in one embodiment, each of the first pixels 100, the second pixels 200, and the third pixels 300 comprises an OLED including an anode, an organic emission layer, and a cathode. These configurations are technologies known in the art and further description thereof is omitted for ease of description. In one embodiment, the shape of each of the pixels is defined by the power lines, the pixel defining layer, the anode, or the like.

In the pixel arrangement of Fig. 1, each of the first pixels 100 has a smaller area (e.g., is smaller in area) than neighboring second pixels 200 and third pixels 300, and has a polygon shape. The first pixels 100 have an octagonal shape among the polygon shapes. In other embodiments, which are not part of the present invention, the first pixels 100 have one or more of various polygon shapes such as a triangle, a rectangle, a pentagon, a hexagon, a heptagon, and the like. For example, the first pixels 100 that neighbor each other among the plurality of first pixels 100 may have hexagon shapes that are symmetrical to each other. In one embodiment, each of the plurality of first pixels 100 has the same hexagonal shape.

In one embodiment, the first pixels 100 are spaced apart from each other and arranged in rows, such as along a first virtual straight line VL1. In one embodiment, the first pixels 100 emit green light, and include an organic emission layer for emitting green light. In other embodiments, the first pixels 100 include an organic emission layer that emits light of one or more of various colors such as blue, red, or white color for emitting blue light, red light, or white light.

In the drawing, the second pixels 200 are arranged diagonally with respect to the first pixels 100, namely at first vertices P1 along one diagonal of a virtual square VS having one of the first pixels 100 as a center point (or center) of the virtual square VS. In a similar fashion, in the drawing, the third pixels 300 are arranged diagonally with respect to the first pixels 100, namely at second vertices P2 along the other diagonal of the virtual square VS.

In the virtual square VS of the drawing, each of the second pixels 200 is separated from the first pixel 100, and is centered at one of the first vertices P1 of the virtual square VS. Each of the second pixels 200 has a larger area than the neighboring first pixel 100 and the neighboring third pixels 300, and has a hexagonal shape. In other embodiments, the second pixels 200 have one or more of various polygonal shapes such as a triangle, a rectangle, a pentagon, a hexagon, a heptagon, and the like.

In the drawing, the second pixels 200 each have the same hexagonal shape. In addition, the second pixels 200 are arranged diagonally and separated from each other by the first pixels 100. In one embodiment, the second pixels 200 emit blue light, and include an organic emission layer for emitting blue light. In other embodiments, the second pixels 200 include an organic emission layer that emits light of one or more of various colors such as red, green, or white for emitting red light, green light, or white light.

In a similar fashion, in the virtual square VS of the drawing, each of the third pixels 300 is separated from the first pixel 100 and the second pixels 200, and is centered at one of the second vertices P2 neighboring the first vertices P1 of the virtual square VS. Each of the third pixels 300 has a larger area than the neighboring first pixel 100 and a smaller area than the neighboring second pixels 200. The third pixels 300 preferably have a quadrilateral shape among polygon shapes. In other embodiments, the third pixels 300 may have one or more of various polygonal shapes such as a triangle, a rectangle, a pentagon, a hexagon, a heptagon, and the like.

In Fig. 1, the third pixels 300 each have the same quadrilateral shape. In addition, the third pixels 300 are arranged diagonally and separated from each other by the first pixels 100. In one embodiment, the third pixels 300 emit red light, and include an organic emission layer for emitting red light. In other embodiments, the third pixels 300 include an organic emission layer that emits light of one or more of various colors such as blue, green, or white for emitting emit blue light, green light, or white light.

In Fig. 1, each of the second pixels 200 and the third pixels 300 has a hexagonal shape and a quadrilateral shape, respectively. In another embodiment, each of the second pixels 200 and the third pixels 300 respectively has a quadrilateral shape and a hexagonal shape. That is, in this other embodiment, one of the second pixels 200 or the third pixels 300 has a hexagonal shape and the other has a quadrilateral shape.

In one embodiment, the first pixels 100, the second pixels 200, and the third pixels 300 respectively emit green light, blue light, and red light. In other embodiments, the first pixels 100, the second pixels 200, and the third pixels 300 emit light of the same color. In still other embodiments, the first pixels 100, the second pixels 200, and the third pixels 300 emit light of different colors. In some embodiments, the first pixels 100 emit green light, and one of the second pixels 200 or the third pixels 300 emit blue light while the other emit red light.

In Fig. 1, the third pixels 300 and the second pixels 200 are spaced apart from each other and alternately arranged in rows, such as along a second virtual straight line VL2. In a similar fashion, in the drawing, the third pixels 300 and the second pixels 200 are spaced apart from each other and alternately arranged in columns. Accordingly, in the virtual square VS, two of the second pixels 200 have their corresponding centers positioned at the first vertices P1 and two of the third pixels 300 have their corresponding centers positioned at the second vertices P2 to enclose a corresponding one of the first pixels 100 in the virtual square VS.

As described and illustrated in Fig. 1, the center of each of the second pixels 200 is positioned at one of the first vertices P1 of the virtual square VS. In addition, the center of the corresponding first pixel 100 is the center of the virtual square VS. Further, the center of each of the third pixels 300 is positioned at one of the second vertices P2. Therefore, the plurality of second pixels 200 of which the centers are positioned at the first vertices P1 and the plurality of third pixels 300 of which the centers are positioned at the second vertices P2 respectively enclose one of the first pixels 100 in the virtual square VS.

Further, the first pixels 100, the second pixels 200, and the third pixels 300 have polygon shapes. In Fig. 1, the distance between one of the first pixels 100 and an adjacent one of the second pixels 200 as well as a distance between one of the first pixels 100 and an adjacent one of the third pixels 300 is the same first length L1. In addition, a distance between one of the second pixels 200 and an adjacent one of the third pixels 300 is a second length L2 that is different from the first length L1. Further, in the drawing, a distance between neighboring first pixels 100 is a third length L3 that is longer than the first length L1 and the second length L2.

For example, in some embodiments, the first length L1 is between 15 µm (micrometers) and 35 µm, the second length L2 is between 20 µm and 45 µm, and the third length L3 is between 25 µm and 65 µm.

Therefore, gaps of the first length L1 are formed between adjacent pairs of the first pixels 100 and the second pixels 200, and between adjacent pairs of the first pixels 100 and the third pixels 300. In addition, the gaps of the third length L3 that is longer than the first length L1 are formed between the neighboring ones of the first pixels 100. In one embodiment, this results in improved deposition reliability in the deposition process using the fine metal mask to form the green, blue, and red organic emission layers respectively included in the first pixels 100, the second pixels 200, and the third pixels 300.

In addition, in one embodiment, the plurality of second pixels 200 and the plurality of third pixels 300 are arranged to enclose the first pixels 100 in the virtual squares VS so that an aperture ratio of each of the first pixels 100, the second pixels 200, and the third pixels 300 can be improved. Accordingly, in one embodiment, the manufacturing time and the manufacturing cost of the OLED display is reduced and the display quality of the image of the OLED display is improved.

Further, in the pixel arrangement structure of the OLED display of the drawing according to an exemplary embodiment of the present invention, the second pixels 200 that emit blue light have the shortest life span among the first pixels 100, the second pixels 200, and the third pixels 300. Accordingly, the second pixels 200 have a larger area than the first pixels 100 and the third pixels 300, thereby suppressing the deterioration of the life span of the OLED display. That is, in one embodiment, the pixel arrangement structure of the OLED display of the drawing provides improved life span.

As described above, in the pixel arrangement structure of the OLED display of Fig. 1 according to an exemplary embodiment of the present invention, the first pixels 100, the second pixels 200, and the third pixels 300 have simple polygonal shapes such as an octagon, a hexagon, and a quadrangle. In consideration of the deposition process of the organic emission layer, which in one embodiment is a unique manufacturing feature of the OLED display, a center of one of the first pixels 100 is positioned at the center of the virtual square VS, a center of one of the second pixels 200 is positioned at the first vertex P1, and a center of one of the third pixels 300 is positioned at the second vertex P2 to both improve deposition reliability of the organic emission layer in the deposition process using the fine metal mask and improve an aperture of each of the first, second, and third pixels 100, 200, and 300.

That is, according to an exemplary embodiment of the present invention as illustrated in the drawing, the pixel arrangement structure of the OLED display includes a plurality of first pixels 100 having an octagonal shape, a plurality of second pixels 200 having a hexagonal shape, and a plurality of third pixels 300 having a quadrilateral shape. In one or more embodiments, the shapes and arrangement of the first pixels 100, the second pixels 200, and the third pixels 300 improve the deposition reliability of the organic emission layer while also improving the aperture ratio of each of the first pixels 100, the second pixels, 200, and the third pixels 300.

While this invention has been described in connection with what is presently considered to be practical exemplary embodiments, it is to be understood that the invention is not limited to the disclosed embodiments, but, on the contrary, is intended to cover various modifications included within the scope of the appendec claims.

### <Description of some symbols>

first pixel 100, second pixels 200, third pixels 300

## Claims

1. A pixel arrangement structure of an organic light emitting diode display, comprising:
first pixels (100) each having a center coinciding with a center of a virtual square (VS);
second pixels (200) separated from the first pixels (100) and each having a center at a first vertex (P1) of the virtual square (VS), wherein each of the second pixels (200) located at a first vertex (P1) of a diagonal line of the virtual square (VS) is spaced apart from a second pixel (200) located at the other vertex (P1) of the diagonal line with a first pixel (100) interposed therebetween; and
third pixels (300) separated from the first pixels (100) and the second pixels (200), and each having a center at a second vertex (P2) neighboring the first vertex (P1) of the virtual square (VS),
wherein a distance between each of the first pixels (100) and an adjacent second pixel (200) as well as a distance between each of the first pixels (100) and an adjacent third pixel (300) is a same first length (L1),
wherein a distance between each of the second pixels (200) and an adjacent third pixel (300) is a same second length (L2) different from the first length (L1), and a distance between the two adjacent first pixels (100) is a third length (L3) that is longer than the first length (L1) and the second length (L2),
wherein the first pixels (100), the second pixels (200), and the third pixels (300) have polygonal shapes,
**characterized in that**
the first pixels (100) have an octagonal shape, and the second pixels (200) have a different shape from a shape of the third pixels (300),
each of the second pixels (200) and the third pixels (300) is larger in area than the first pixel (100),
the first length (L1) is between 15 µm and 35 µm, the second length (L2) is between 20 µm and 45 µm, and the third length (L3) is between 25 µm and 65 µm.

2. The pixel arrangement structure of claim 1, wherein
the third pixels (300) are separated from each other by a first pixel (100).

3. The pixel arrangement structure of claim 1 or 2, wherein
the second pixels (200) and the third pixels (300) enclose a first pixel (100) in the virtual square (VS).

4. The pixel arrangement structure of any of the preceding claims, wherein either the second pixels (200) or the third pixels (300) each have a hexagonal shape and the other one of the second pixels (200) or the third pixels (300) have a quadrilateral shape.

5. The pixel arrangement structure of claim 4, wherein
the pixel arrangement comprises:
a pair of virtual squares (VS) sharing a common side, and
a pair of first pixels (100) having centers respectively coinciding with centers of the virtual squares (VS), and
the first pixels (100) have octagonal shapes that are symmetrical to each other with respect to the common side of the virtual squares (VS).

6. The pixel arrangement structure of claim 4 or 5, wherein each of the second pixels (200) is larger in area than each of the third pixels (300).

7. The pixel arrangement structure of claim 1, wherein
the pixel arrangement structure comprises a pair of virtual squares (VS) sharing a common side, and
a pair of first pixels (100) having centers respectively coinciding with centers of the virtual squares (VS).

8. The pixel arrangement structure of any of the preceding claims, wherein the first pixels (100), the second pixels (200), and the third pixels (300) are configured to emit light of different color.

9. The pixel arrangement structure of claim 8, wherein
the first pixels (100) are configured to emit green light,
either the second pixels (200) or the third pixels (300) are each configured to emit blue light, and
the other one of the second pixels (200) or the third pixels (300) are each configured to emit red light.

## Patentansprüche

1. Pixelanordnungsstruktur einer organischen Leuchtdiodenanzeige, umfassend:
erste Pixel (100), die jeweils einen Mittelpunkt aufweisen, der mit dem Mittelpunkt eines virtuellen Quadrats (VS) übereinstimmt;
zweite Pixel (200), die von den ersten Pixeln (100) getrennt sind und jeweils einen Mittelpunkt an einem ersten Eckpunkt (P1) des virtuellen Quadrats (VS) aufweisen, wobei jedes aus den zweiten Pixeln (200), das an ein einem ersten Eckpunkt (P1) einer diagonalen Linie des virtuellen Quadrats (VS) angeordnet ist, von einem zweiten Pixel (200), das an dem anderen Eckpunkt (P1) der diagonalen Linie angeordnet ist, beabstandet ist, wobei ein erstes Pixel (100) dazwischen angeordnet ist; und
dritte Pixel (300), die von den ersten Pixeln (100) und den zweiten Pixeln (200) beabstandet sind und jeweils einen Mittelpunkt an einem zweiten Eckpunkt (P2), der dem ersten Eckpunkt (P1) des virtuellen Quadrats (VS) benachbart ist, aufweisen,
wobei eine Entfernung zwischen jedem aus den ersten Pixeln (100) und einem benachbarten zweiten Pixel (200) sowie eine Entfernung zwischen jedem aus den ersten Pixeln (100) und einem benachbarten dritten Pixel (300) eine gleiche erste Länge (L1) ist,
wobei eine Entfernung zwischen jedem aus den zweiten Pixeln (200) und einem benachbarten dritten Pixel (300) eine gleiche zweite Länge (L2) ist, die sich von der ersten Länge (L1) unterscheidet, und eine Entfernung zwischen zwei benachbarten ersten Pixeln (100) eine dritte Länge (L3) ist, die länger ist als die erste Länge (L1) und die zweite Länge (L2),
wobei die ersten Pixel (100), die zweiten Pixel (200) und die dritten Pixel (300) polygonale Formen aufweisen,
**dadurch gekennzeichnet, dass**
die ersten Pixel (100) eine oktogonale Form aufweisen und die zweiten Pixel (200) eine Form aufweisen, die sich von der Form der dritten Pixel (300) unterscheidet,
jedes aus den zweiten Pixeln (200) und den dritten Pixeln (300) eine größere Fläche aufweist als das erste Pixel (100),
die erste Länge (L1) zwischen 15 µm und 35 µm beträgt, die zweite Länge (L2) zwischen 20 µm und 45 µm beträgt und die dritte Länge (L3) zwischen 25 µm und 65 µm beträgt.

2. Pixelanordnungsstruktur nach Anspruch 1, wobei die dritten Pixel (300) durch ein erstes Pixel (100) voneinander getrennt sind.

3. Pixelanordnungsstruktur nach Anspruch 1 oder 2, wobei
die zweiten Pixel (200) und die dritten Pixel (300) ein erstes Pixel (100) in dem virtuellen Quadrat (VS) umschließen.

4. Pixelanordnungsstruktur nach einem der vorangehenden Ansprüche, wobei entweder die zweiten Pixel (200) oder die dritten Pixel (300) jeweils eine hexagonale Form aufweisen und die anderen aus den zweiten Pixeln (200) oder den dritten Pixeln (300) eine viereckige Form aufweisen.

5. Pixelanordnungsstruktur nach Anspruch 4, wobei die Pixelanordnung Folgendes umfasst:
ein Paar von virtuellen Quadraten (VS), die eine gemeinsame Seite aufweisen, und
ein Paar von ersten Pixeln (100), die Mittelpunkte aufweisen, welche jeweils mit Mittelpunkten der virtuellen Quadrate (VS) übereinstimmen, und
wobei die ersten Pixel (100) oktogonale Formen aufweisen, die in Bezug auf die gemeinsame Seite der virtuellen Quadrate (VS) zueinander symmetrisch sind.

6. Pixelanordnungsstruktur nach Anspruch 4 oder 5, wobei jedes aus den zweiten Pixeln (200) eine größere Fläche aufweist als jedes aus den dritten Pixeln (300).

7. Pixelanordnungsstruktur nach Anspruch 1, wobei
die Pixelanordnungsstruktur umfasst: ein Paar von virtuellen Quadraten (VS), die eine gemeinsame Seite aufweisen, und
ein Paar von ersten Pixeln (100), die Mittelpunkte aufweisen, welche jeweils mit Mittelpunkten der virtuellen Quadrate (VS) übereinstimmen.

8. Pixelanordnungsstruktur nach einem der vorangehenden Ansprüche, wobei die ersten Pixel (100), die zweiten Pixel (200) und die dritten Pixel (300) dazu ausgestaltet sind, Licht von unterschiedlicher Farbe zu emittieren.

9. Pixelanordnungsstruktur nach Anspruch 8, wobei
die ersten Pixel (100) dazu ausgestaltet sind, grünes Licht zu emittieren,
entweder die zweiten Pixel (200) oder die dritten Pixel (300) jeweils dazu ausgestaltet sind, blaues Licht zu emittieren, und
die anderen aus den zweiten Pixeln (200) oder den dritten Pixeln (300) jeweils dazu ausgestaltet sind, rotes Licht zu emittieren.

## Revendications

1. Structure de disposition de pixels d'un dispositif d'affichage à diodes électroluminescentes organiques, comportant :
de premiers pixels (100) ayant chacun un centre coïncidant avec un centre d'un carré virtuel (VS) ;
de deuxièmes pixels (200) séparés des premiers pixels (100) et ayant chacun un centre à un premier sommet (P1) du carré virtuel (VS), chacun des deuxièmes pixels (200) situé à un premier sommet (P1) d'une ligne diagonale du carré virtuel (VS) étant espacé d'un deuxième pixel (200) situé à l'autre sommet (P1) de la ligne diagonale avec un premier pixel (100) interposé entre eux ; et
de troisièmes pixels (300) séparés des premiers pixels (100) et des deuxièmes pixels (200), et ayant chacun un centre à un second sommet (P2) voisin du premier sommet (P1) du carré virtuel (VS),
dans laquelle une distance entre chacun des premiers pixels (100) et un deuxième pixel (200) adjacent ainsi qu'une distance entre chacun des premiers pixels (100) et un troisième pixel (300) adjacent est une même première longueur (L1),
dans laquelle une distance entre chacun des deuxièmes pixels (200) et un troisième pixel (300) adjacent est une même deuxième longueur (L2) différente de la première longueur (L1), et une distance entre les deux premiers pixels (100) adjacents est une troisième longueur (L3) qui est plus longue que la première longueur (L1) et la deuxième longueur (L2),
dans laquelle les premiers pixels (100), les deuxièmes pixels (200) et les troisièmes pixels (300) présentent des formes polygonales,
**caractérisée en ce que**
les premiers pixels (100) présentent une forme octogonale, et les deuxièmes pixels (200) présentent une forme différente d'une forme des troisièmes pixels (300),
chacun des deuxièmes pixels (200) et des troisièmes pixels (300) est plus grand en surface que le premier pixel (100),
la première longueur (L1) est comprise entre 15 µm et 35 µm, la deuxième longueur (L2) est comprise entre 20 µm et 45 µm, et la troisième longueur (L3) est comprise entre 25 µm et 65 µm.

2. Structure de disposition de pixels selon la revendication 1, dans laquelle
les troisièmes pixels (300) sont séparés les uns des autres par un premier pixel (100).

3. Structure de disposition de pixels selon la revendication 1 ou 2, dans laquelle
les deuxièmes pixels (200) et les troisièmes pixels (300) entourent un premier pixel (100) dans le carré virtuel (VS).

4. Structure de disposition de pixels selon l'une quelconque des revendications précédentes, dans laquelle soit les deuxièmes pixels (200), soit les troisièmes pixels (300) présentent chacun une forme hexagonale et les autres parmi les deuxièmes pixels (200) ou les troisièmes pixels (300) présentent une forme quadrilatérale.

5. Structure de disposition de pixels selon la revendication 4, dans laquelle
la disposition de pixels comporte :
une paire de carrés virtuels (VS) partageant un côté commun, et
une paire de premiers pixels (100) ayant des centres coïncidant respectivement avec des centres des carrés virtuels (VS), et
les premiers pixels (100) présentent des formes octogonales qui sont symétriques entre elles par rapport au côté commun des carrés virtuels (VS).

6. Structure de disposition de pixels selon la revendication 4 ou 5, dans laquelle chacun des deuxièmes pixels (200) est plus grand en surface que chacun des troisièmes pixels (300).

7. Structure de disposition de pixels selon la revendication 1, dans laquelle
la structure de disposition de pixels comporte une paire de carrés virtuels (VS) partageant un côté commun, et
une paire de premiers pixels (100) ayant des centres coïncidant respectivement avec des centres des carrés virtuels (VS).

8. Structure de disposition de pixels selon l'une quelconque des revendications précédentes, dans laquelle les premiers pixels (100), les deuxièmes pixels (200) et les troisièmes pixels (300) sont configurés pour émettre une lumière de couleur différente.

9. Structure de disposition de pixels selon la revendication 8, dans laquelle
les premiers pixels (100) sont configurés pour émettre une lumière verte,
soit les deuxièmes pixels (200), soit les troisièmes pixels (300) sont chacun configurés pour émettre une lumière bleue, et
les autres parmi les deuxièmes pixels (200) ou les troisièmes pixels (300) sont chacun configurés pour émettre une lumière rouge.
